# EUROPEAN PATENT APPLICATION

(11) **EP 3 910 585 A1**
(43) Date of publication of application: **17.11.2021**
(21) Application number: 20776395.4
(22) Date of filing: 17.03.2020
(51) Int. Cl.: G06T 5/00

(54) **IMAGE PROCESSING METHOD AND DEVICE**

(30) Priority: 28.03.2019 CN 201910243416
(71) Applicant: Hangzhou Hikvision Digital Technology Co., Ltd., Hangzhou, Zhejiang 310051 (CN)
(72) Inventor: BIAN, Xuefei, Hangzhou, Zhejiang 310051 (CN); MA, Qiang, Hangzhou, Zhejiang 310051 (CN); WANG, Jun, Hangzhou, Zhejiang 310051 (CN)
(74) Representative: BRP Renaud & Partner mbB Rechtsanwälte Patentanwälte Steuerberater
(86) International application number: PCT/CN2020/079750
(87) International publication number: WO 2020/192499

(57) **Abstract**

The embodiment of the present application provides an image processing method and device, and relates to the technical field of image processing. The method includes: obtaining a to-be-processed image; obtaining a first image that is obtained by performing resolution reduction processing on the to-be-processed image; performing image processing on the first image to obtain a second image; and increasing a resolution of the second image to a preset resolution as an image processing result. Applying the solution provided in the embodiments of the present application for image processing can reduce the requirements on image resolution in an image processing process.

## Description

The present application claims the priority to a Chinese patent application No. 201910243416.9 filed with the China National Intellectual Property Administration on March 28, 2019 and entitled "IMAGE PROCESSING METHOD AND DEVICE", which is incorporated herein by reference in its entirety.

### TECHNICAL FIELD

The present application relates to the field of image processing technology, and in particular, to an image processing method and device.

### BACKGROUND

With the rapid development of hardware technology, devices such as analog cameras, hard disk video recorders and the like commonly used in the field of video monitoring become more and more mature, and then a variety of image processing devices with different processing capabilities appear.

For example, a 720P non-realtime image encoding device is capable of encoding images with a maximum resolution corresponding to 720P. However, in the practical application, with the development of hardware technology, images acquired by image acquisition devices, such as cameras, mobile phones, owned by more and more users have a resolution corresponding to 1080P.

In this case, it is difficult for the 720P non-realtime image encoding device described above to process images with the resolution corresponding to 1080P. It can only process images with the resolution corresponding to 720P or below.

It can be seen that the existing image processing device for image processing has higher requirements on the resolution of the to-be-processed image.

### SUMMARY

Embodiments of the present application aim to provide an image processing method and device to reduce the requirements on image resolution in an image processing process. The following specific technical solutions are provided.

In a first aspect, an embodiment of the present application provides an image processing method, including:
obtaining a to-be-processed image;
obtaining a first image that is obtained by performing resolution reduction processing on the to-be-processed image;
performing image processing on the first image to obtain a second image; and
increasing a resolution of the second image to a preset resolution as an image processing result.

In an embodiment of the present application, obtaining the first image that is obtained by performing resolution reduction processing on the to-be-processed image includes:
obtaining the first image that is obtained by performing resolution reduction processing on the to-be-processed image in a preset Half mode, wherein a resolution in an image width direction is reduced by half and/or a resolution in an image height direction is reduced by half.

In an embodiment of the present application, obtaining the to-be-processed image includes:
obtaining an analog image and converting the analog image to a digital image; and
storing into a random memory the to-be-processed image determined based on the digital image.

In an embodiment of the present application, obtaining the first image that is obtained by performing resolution reduction processing on the to-be-processed image in the preset Half mode includes:
obtaining the to-be-processed image from the random memory; and
obtaining the first image that is obtained by performing resolution reduction processing on the to-be-processed image in the preset Half mode.

In an embodiment of the present application, storing into the random memory the to-be-processed image determined based on the digital image includes:
directly determining the digital image as the to-be-processed image, and performing resolution reduction processing on the to-be-processed image in the preset Half mode;
storing into the random memory the to-be-processed image subjected to the resolution reduction processing;
accordingly, obtaining the first image that is obtained by performing resolution reduction processing on the to-be-processed image in the preset Half mode includes:
   obtaining the to-be-processed image stored in the random memory as the first image.

In an embodiment of the present application, after converting the analog image to the digital image, the method further includes:
pre-processing the digital image to remove image noise in the digital image;
accordingly, storing into the random memory the to-be-processed image determined based on the digital image includes:
   storing into the random memory the to-be-processed image determined based on the digital image with image noise removed.

In a second aspect, an embodiment of the present application provides an image processing device, including: an image acquirer and an image processor, wherein,
the image acquirer is configured for obtaining a to-be-processed image; and
the image processor is configured for obtaining a first image that is obtained by performing resolution reduction processing on the to-be-processed image; performing image processing on the first image to obtain a second image; and increasing a resolution of the second image to a preset resolution as an image processing result.

In an embodiment of the present application, the image processor is specifically configured for obtaining the first image that is obtained by performing resolution reduction processing on the to-be-processed image in a preset Half mode, wherein a resolution in an image width direction is reduced by half and/or a resolution in an image height direction is reduced by half.

In an embodiment of the present application, the image acquirer is an analog-to-digital converter, the device further includes: an image input interface and a random memory; wherein,
the analog-to-digital converter is configured for obtaining an analog image, converting the analog image to a digital image, and sending an image to the image input interface based on the digital image;
the image input interface is configured for receiving the image sent by the analog-to-digital converter, and sending an image to the random memory based on the received image; and
the random memory is configured for storing the to-be-processed image determined based on the received image.

In an embodiment of the present application, the analog-to-digital converter is specifically configured for sending the digital image to the image input interface;
the image input interface is specifically configured for sending the digital image to the random memory;
the random memory is specifically configured for storing the digital image as the to-be-processed image; and
the image processor is specifically configured for obtaining the to-be-processed image from the random memory; and obtaining the first image that is obtained by performing resolution reduction processing on the to-be-processed image in the preset Half mode.

In an embodiment of the present application, the analog-to-digital converter is specifically configured for directly determining the digital image as the to-be-processed image, performing resolution reduction processing on the to-be-processed image in the preset Half mode, and sending to the image input interface the to-be-processed image subjected to the resolution reduction processing;
the image input interface is specifically configured for sending the to-be-processed image to the random memory;
the random memory is specifically configured for storing the to-be-processed image; and
the image processor is specifically configured for obtaining an image stored in the random memory as the first image.

In an embodiment of the present application, the image input interface is integrated with a resolution reduction chip;
the analog-to-digital converter is specifically configured for sending the digital image to the image input interface;
the image input interface is specifically configured for receiving the digital image sent by the analog-to-digital converter, performing resolution reduction processing on the digital image in the preset Half mode by the resolution reduction chip, and sending an image obtained by performing resolution reduction processing to the random memory by the resolution reduction chip;
the random memory is specifically configured for storing the received image as the to-be-processed image; and
the image processor is specifically configured for obtaining the to-be-processed image from the random memory as the first image.

In an embodiment of the present application, the device further includes an image noise reduction chip:
the image input interface is specifically configured for receiving the digital image sent by the analog-to-digital converter, and sending the digital image to the image noise reduction chip;
the image noise reduction chip is configured for pre-processing the digital image to remove image noise in the digital image, and sending to the random memory the digital image with image noise removed; and
the random memory is specifically configured for storing the to-be-processed image determined based on the digital image with image noise removed.

In a third aspect, an embodiment of the present application provides a computer readable storage medium, which stores a computer program therein, wherein the computer program, when executed by a processor, implements the steps of the image processing method described in the embodiments of the present application.

In a fourth aspect, an embodiment of the present application further provides a computer program product containing instructions which, when running on a computer, causes a computer to execute the image processing method according to the embodiments of the present application.

As can be seen from above, when the solutions according to the above embodiments of the present application are applied for image processing, after obtaining a to-be-processed image, the first image is obtained which is obtained by performing resolution reduction processing on the to-be-processed image, and then image processing otherwise needed to be performed on the to-be-processed image is completed by performing image processing on the first image. In addition, in order to ensure that the resolution of the final image processing result is consistent with actual requirements, after obtaining the second image by performing image processing on the first image, the resolution of the second image is further increased. Since the first image is an image that is obtained by performing resolution reduction processing on the to-be-processed image, the resolution of the first image is smaller than that of the to-be-processed image. Therefore, when the solutions according to the embodiments of the present application are applied for image processing, the resolution range of the image processed by the image processing device can be expanded, thus when the solutions according to the embodiments of the present application are applied for image processing, the requirements on image resolution can be reduced.

### BRIEF DESCRIPTION OF DRAWINGS

In order to more clearly describe the technical solutions of the embodiments of the present application or of the prior art, drawings that need to be used in embodiments and the prior art will be briefly described below. Obviously, the drawings provided below are for only some embodiments of the present application. Those skilled in the art can also obtain other drawings based on these drawings without any creative efforts.
Fig. 1 is a schematic flowchart of an image processing method according to an embodiment of the present application;
Fig. 2 is a schematic flowchart of another image processing method according to an embodiment of the present application;
Fig. 3 is a schematic structural diagram of an image processing device according to an embodiment of the present application;
Fig. 4 is a schematic structural diagram of another image processing device according to an embodiment of the present application.

### DETAILED DESCRIPTION

In order to make the objectives, technical solutions, and advantages of the present application clearer and more understandable, the present application will be described in more detail below with reference to the appended drawings and embodiments. Obviously, the described embodiments are only some, and not all, of the embodiments of the present application. All other embodiments obtained based on the embodiments of the present application by those skilled in the art without any creative efforts fall into the scope of protection defined by the present application.

The execution subject of the embodiments of the present application may be an image processing device.

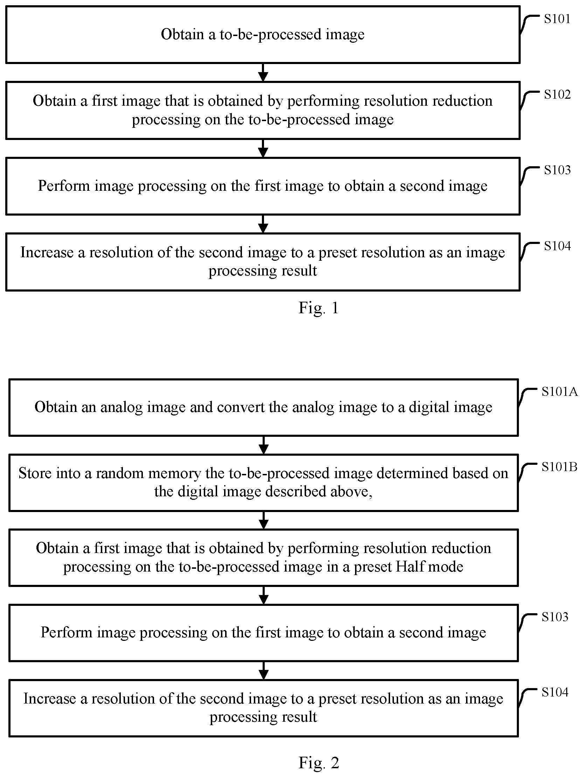

Fig. 1 shows a schematic flowchart of an image processing method according to an embodiment of the present application, wherein the method includes the following steps.

S101: obtain a to-be-processed image.

Specifically, in this step, it is possible to directly obtain a to-be-processed digital image as the to-be-processed image, or it is possible to perform, after a to-be-processed analog image is obtained, an analog-to-digital conversion on the analog image to obtain a digital image as the to-be-processed image.

S102: obtain a first image that is obtained by performing resolution reduction processing on the to-be-processed image.

Specifically, performing resolution reduction processing on the to-be-processed image may be performing downsampling processing on the to-be-processed image. Obviously, it may also be reducing the size of the to-be-processed image. Any manner that can reduce the resolution of the to-be-processed image may be applied to this step, which is not limited in the embodiment of the present application.

In an embodiment of the present application, obtaining a first image that is obtained by performing resolution reduction processing on the to-be-processed image may specifically be obtaining a first image that is obtained by performing resolution reduction processing on the to-be-processed image in a preset Half mode.

In the Half mode, the resolution in an image width direction is reduced by half and/or the resolution in an image height direction is reduced by half.

That is, in the Half mode, one of the following three cases may be present:
case 1: reducing the resolution in an image width direction by half;
case 2: reducing the resolution in an image height direction by half;
case 3: reducing the resolution in the image width direction by half and reducing the resolution in the image height direction by half.

For example, when the resolution of an image with the resolution corresponding to 1080P is reduced in the Half mode, that is, when the resolution of an image with the resolution of 1920×1080 is reduced in the Half mode, the obtained first image may be one of the following three cases.

The first case: when the resolution of the image is reduced by half in the width direction, the resolution of the image after the resolution reduction is 960x1080, that is, the resolution of the first image is 960x1080. In this case, the data amount of the first image is reduced by half with respect to the image before the resolution reduction, so that the required memory resources and CPU resources can be reduced by half for subsequent image processing.

The second case: when the resolution of the image is reduced by half in the image height direction, the resolution of the image after the resolution reduction is 1920x540, that is, the resolution of the first image is 1920x540. In this case, the data amount of the first image is also reduced by half with respect to the image before the resolution reduction, so that the required memory resources and CPU resources can be reduced by half for subsequent image processing.

The third case: when the resolution of the image is reduced by half in both the width direction and height direction, the resolution of the image after the resolution reduction is 960x540, that is, the resolution of the first image is 960x540. In this case, the data amount of the first image is reduced by three-quarters with respect to the image before the resolution reduction, so that the required memory resources and CPU resources can be reduced by three-quarters for subsequent image processing.

It is worth mentioning that during the experiment, the inventor found that when the Half mode is selected in which the resolution of an image is reduced by half in the width direction but is not reduced in the height direction, when performing image processing on the first image, and increasing the resolution of a second image obtained by performing image processing, that is, enlarging the image in the width direction, the image has less subjective and objective impacts on the user, and the restored image has better quality.

In addition, the resolution reduction processing in the image width direction and/or in the image height direction can also be performed based on other ratios. For example, the other ratios may be 2:3, 3:4, etc., that is, the resolution is reduced by two-thirds, three-quarters, etc.

S103: perform image processing on the first image to obtain a second image.

Specifically, when performing image processing on the first image, the first image may be processed based on the requirements in the specific applications. For example, encoding processing, filtering processing, etc. are performed on the first image.

When performing image processing described above is performing encoding processing on the first image, the execution subject in the solutions according to the embodiments of the present application can be a device with a video encoding function such as an hard disc video recorder, a network video recorder; or can be a device with an image acquisition function and a video encoding function such as a camera with the video encoding function, a device with integrated lens and processors with the encoding function.

S104: increase a resolution of the second image to a preset resolution as an image processing result.

Specifically, the preset resolution may be an original resolution of the to-be-processed image, that is, a resolution of the to-be-processed image before the resolution reduction processing. The preset resolution can also be a resolution that is set in advance. In one case, the preset resolution can be a resolution that is pre-determined based on the resolution of the display device configured for displaying the image processing result.

For example, if the resolution of the to-be-processed image is 1920x1080, and the resolution of the first image is 960×1080, the preset resolution can be 1920×1080 or 1440×1080.

If the resolution of the display device is 1920×1080, the preset resolution is also 1920×1080 so that the display device has a better display effect. If the resolution of the display device is 1440×1080, the preset resolution is also 1440×1080, so that the display device has a better display effect,.

As can be seen from above, when the solutions according to the above embodiments are applied for image processing, after obtaining a to-be-processed image, a first image is obtained which is obtained by performing resolution reduction processing on the to-be-processed image, and then image processing otherwise needed to be performed on the to-be-processed image is completed by performing image processing on the first image. In addition, in order to ensure that the resolution of the final image processing result is consistent with actual requirements, after obtaining the second image by performing image processing on the first image, the resolution of the second image is further increased. Since the first image is an image that is obtained by performing resolution reduction processing on the to-be-processed image, the resolution of the first image is smaller than that of the to-be-processed image. Therefore, when the solutions according to the above embodiments are applied for image processing, the resolution range of the image processed by the image processing device can be expanded, thus when the solutions according to the above embodiments are applied for image processing, the requirements on image resolution can be reduced.

That is, the image processing device widens the resolution range of images that can be processed, thereby the compatibility of the image processing device with respect to an accessed image is improved from the perspective of the resolution.

In addition, since the resolution of the image processed by the image processing device is reduced, the data amount of the processed image is also reduced. Therefore, even if the maximum resolution of the image that can be processed by the image processing device is low, an image with a high original resolution can also be processed in real time.

Since image processing is performed on an image by the image processing device, and the image processing device may contain different hardware resources which cooperate with each other to complete image processing. In view of this, in an embodiment of the present application, a schematic flowchart of another image processing method is provided with reference to Fig. 2. Compared with the foregoing embodiments, in this embodiment, the step S101 of obtaining a to-be-processed image includes:
S101A: obtain an analog image and convert the analog image to a digital image.

The analog image is converted to a digital image, that is, an image represented by a two-dimensional digital group. Specifically, the analog image can be converted to a digital image by Analog-to-Digital Converter (ADC).

S101B: store into a random memory the to-be-processed image determined based on the digital image.

The to-be-processed image is stored into the random memory, so that when the number of the to-be-processed images obtained in unit time exceeds the number of images processed in unit time, the to-be-processed images that cannot be processed are cached, thereby effectively preventing the phenomenon that the to-be-processed images that cannot be processed in time are lost.

Specifically, the random memory can be a Double Data SDRAM (DDR). Since the cost of DDR is generally low, the use of DDR as a random memory can save the cost of the image acquisition device to a certain extent.

In the following, on the basis of the embodiment shown in Fig. 2, the image processing method according to the embodiment of the present application will be described through two more specific embodiments.

In an embodiment of the present application, the to-be-processed image stored in the random memory can be the digital image.

In this case, obtaining the first image that is obtained by performing resolution reduction processing on the to-be-processed image in the preset Half mode can be implemented by the following steps:
obtaining the to-be-processed image from the random memory; and
obtaining the first image that is obtained by performing resolution reduction processing on the to-be-processed image in the preset Half mode.

That is to say, in this case, the to-be-processed image stored in the random memory is an image before the resolution reduction processing. Therefore, in order to obtain the first image, it is necessary to read the to-be-processed image from the random memory, and perform resolution reduction processing on the read image.

In another embodiment of the present application, the image stored in the random memory can be an image after the resolution reduction processing. In view of this, storing into the random memory the to-be-processed image determined based on the digital image can be implemented by the following steps:
directly determining the digital image as the to-be-processed image, and performing resolution reduction processing on the to-be-processed image in the preset Half mode; and
storing into the random memory the to-be-processed image subjected to the resolution reduction processing.

As can be seen from above, in this case, the to-be-processed image stored in the random memory is an image subjected to the resolution reduction processing in a preset Half mode, i.e., the first image.

Therefore, corresponding to the above case, obtaining the first image that is obtained by performing resolution reduction processing on the to-be-processed image in the preset Half mode is: obtaining the to-be-processed image stored in the random memory as a first image.

In an embodiment of the present application, after converting the analog image to the digital image, the digital image can be pre-processed to remove image noise in the digital image.

In this case, storing into the random memory the to-be-processed image determined based on the digital image is specifically: storing into the random memory the to-be-processed image determined based on the digital image with image noise removed.

Image noise in the digital image is firstly removed before performing image processing on the first image, so that a high-quality first image can be obtained in the subsequent process, thereby improving the effect of image processing.

Corresponding to the image processing method, an embodiment of the present application further provides an image processing device.

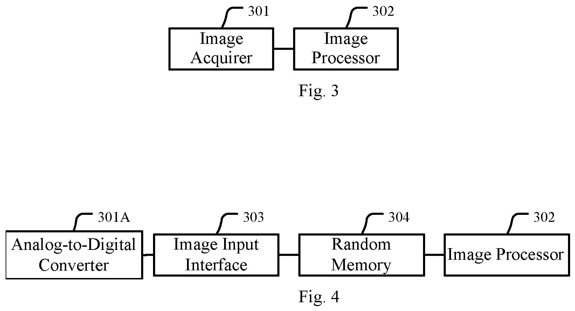

Fig. 3 is a schematic structural diagram of an image processing device according to an embodiment of the present application. The device includes an image acquirer 301 and an image processor 302, wherein,
the image acquirer 301 is configured for obtaining a to-be-processed image; and
the image processor 302 is configured for obtaining a first image that is obtained by performing resolution reduction processing on the to-be-processed image; performing image processing on the first image to obtain a second image; and increasing a resolution of the second image to a preset resolution as an the image processing result.

In an embodiment of the present application, the image processor 302 is specifically configured for obtaining a first image that is obtained by performing resolution reduction processing on the to-be-processed image in a preset Half mode, wherein the resolution in an image width direction is reduced by half and/or the resolution in an image height direction is reduced by half.

As can be seen from above, when the image processing device according to the embodiments are applied for image processing, after obtaining a to-be-processed image, a first image is obtained which is obtained by performing resolution reduction processing on the to-be-processed image, and then image processing otherwise needed to be performed on the to-be-processed image is completed by performing image processing on the first image. In addition, in order to ensure that the resolution of the final image processing result is consistent with actual requirements, after obtaining the second image by performing image processing on the first image, the resolution of the second image is further increased. Since the first image is an image that is obtained by performing resolution reduction processing on the to-be-processed image, the resolution of the first image is smaller than that of the to-be-processed image. Therefore, when the image processing device according to the embodiments is applied for image processing, the resolution range of the image processed by the image processing device can be expanded, thus when the image processing device according to the embodiments is applied for image processing, the requirements on image resolution can be reduced.

In an embodiment of the present application, with reference to Fig. 4, a schematic structural diagram of another image processing device is provided. Compared with the foregoing embodiments, in this embodiment, the image acquirer 301 is specifically an analog-to-digital converter 301A. The device further includes an image input interface 303 and a random memory 304; wherein,
the analog-to-digital converter 301A is configured for obtaining an analog image, converting the analog image to a digital image, and sending an image to the image input interface 303 based on the digital image;
the image input interface 303 is configured for receiving the image sent by the analog-to-digital converter 301A, and sending an image to the random memory 304 based on the received image; and
the random memory 304 is configured for storing the to-be-processed image determined based on the received image.

Specifically, the analog-to-digital converter 301A can be an ADC, which is a device capable of converting an analog image into an image represented by a two-dimensional digital group.

When the to-be-processed image is one frame in a video, the image input interface 303 can also be a video input interface.

In addition, the image input interface 303 is an interface with respect to the image processor 302. That is, the image input interface 303 is an interface for providing an input image to the image processor 302.

In an embodiment of the present application, the image input interface 303 can send the received image to the display device in addition to sending the received image to the analog-to-digital converter 301A, so that the staff can preview the image before image processing through the display device.

In the solution according to this embodiment, the to-be-processed image is stored in the random memory 304, so that when the number of the to-be-processed images obtained in unit time exceeds the number of images processed in the unit time, the to-be-processed images that cannot be processed in real time are cached, thereby effectively preventing the phenomenon that the to-be-processed images that cannot be processed in time are lost.

Specifically, the random memory 304 can be a DDR. Since the cost of DDR is generally low, the use of DDR as a random memory can save the cost of the image acquisition device to a certain extent.

In the following, on the basis of the embodiment shown in Fig. 4, the image acquisition device according to the embodiment of the present application will be described through three more specific embodiments.

In an embodiment of the present application, the analog-to-digital converter 301A is specifically configured for sending the digital image to the image input interface 303;
the image input interface 303 is specifically configured for sending the digital image to the random memory 304;
the random memory 304 is specifically configured for storing the digital image as a to-be-processed image; and
the image processor 302 is specifically configured for obtaining the to-be-processed image from the random memory 304; and obtaining a first image that is obtained by performing resolution reduction processing on the to-be-processed image in a preset Half mode.

In this case, the to-be-processed image stored in the random memory 304 is a digital image subjected to an analog-to-digital conversion, that is, an image before the resolution reduction processing. The resolution Reduction processing is completed by the image processor 302. Therefore, the image processor 302 can determine how to reduce the resolution of the to-be-processed image according to its actual situation, such as the idle hardware resources.

For example, when the image processor 302 encodes an image, the image processor 302 can determine how to reduce the resolution of the to-be-processed image according to the fluctuation of the current code rate, the image content of each of images being processed continuously, and idle CPU resources, and the like.

In another embodiment of the present application, the analog-to-digital converter 301A is specifically configured for directly determining the digital image as the to-be-processed image, performing resolution reduction processing on the to-be-processed image in the preset Half mode, and sending to the image input interface 303 the to-be-processed image subjected to the resolution reduction processing;
the image input interface 303 is specifically configured for sending the to-be-processed image to the random memory;
the random memory 304 is specifically configured for storing the to-be-processed image; and
the image processor 302 is specifically configured for obtaining the image stored in the random memory as a first image.

In this case, the resolution reduction processing in the Half mode is completed by the analog-to-digital converter 301A, that is, the analog-to-digital converter 301A outputs the to-be-processed image after the resolution reduction, i.e., the first image. Thus, the first image is stored in the random memory 304. In this case, when the image processor 302 obtains the first image, the first image can be directly read from the random memory 304. The resolution reduction processing is completed by the analog-to-digital converter 301A, so that images processed by the subsequent image input interface 303, the random memory 304 and the image processor 302 are images after the resolution reduction, thus reducing the data amount of the images to be processed by each of the devices, and reducing the workload of these devices.

In addition, in the above case, since a front end of the analog-to-digital converter 301A directly interfaces with the image input from the outside, and a rear end thereof outputs an image subjected to the resolution reduction processing, each of the subsequent devices no longer process the high-resolution image. Therefore, this solution of reducing the resolution by the analog-to-digital converter 301A is particularly suitable for the image processing devices with lower overall performance.

In another yet embodiment of the present application, the image input interface 303 is integrated with a resolution reduction chip;
the analog-to-digital converter 301A is specifically configured for sending the digital image to the image input interface;
the image input interface 303 is specifically configured for receiving the digital image sent by the analog-to-digital converter, performing resolution reduction processing on the digital image in the preset Half mode by the resolution reduction chip, and sending to the random memory the image subjected to the resolution reduction processing by the resolution reduction chip ;
the random memory 304 is specifically configured for storing the received image as the to-be-processed image; and
the image processor 302 is specifically configured for obtaining the to-be-processed image from the random memory as a first image.

In this case, the resolution reduction processing in the Half mode is neither completed by the analog-to-digital converter 301A nor the image processor 302, but is completed by the resolution reduction chip integrated in the image input interface 303. In view of this, the image output to the random memory 304 by the image input interface 303 is also the to-be-processed image subjected to the resolution reduction processing, that is, the first image. Thus the image stored in the random memory 304 is the first image. In this case, when the image processor 302 obtains the first image, the first image can be directly read from the random memory 304. The resolution reduction processing is completed by the resolution reduction chip, so that subsequently the data amount of the image sent by the resolution reduction chip to the random memory 304, the data amount of the image stored in the random memory 304, and the data amount of the image to be processed by the image processor 302 are reduced to the data amount of the images after the resolution reduction, thus reducing the workload of these devices.

In addition, based on the above situation, when resolution reduction processing is performed by the resolution reduction chip, the image input interface can actually output the image subjected to the resolution reduction processing, and can also output the image before resolution reduction. In view of this, In an embodiment of the present application, when the image before image processing needs to be previewed in multiple screens, if the user needs to preview a small screen, the image input interface 303 can output to the display device the image subjected to the resolution reduction processing through the resolution reduction chip; and if the user needs to preview a large screen, the image input interface 303 may directly output the image before resolution reduction to the display device.

In an embodiment of the present application, the device further includes an image noise reduction chip:
the image input interface 303 is specifically configured for receiving the digital image sent by the analog-to-digital converter 301A, and sending the digital image to the image noise reduction chip;
the image noise reduction chip is configured for pre-processing the digital image to remove image noise in the digital image, and sending the digital image with image noise removed to the random memory 304; and
the random memory 304 is specifically configured for storing the to-be-processed image determined based on the digital image with image noise removed.

Before performing image processing on the first image, the image noise therein is removed firstly, so that a high quality first image can be obtained in the subsequent process, thus improving the effect of image processing.

Corresponding to the foregoing the image processing method, the embodiments of the present application further provide an image processing apparatus.

In an embodiment of the present application, an image processing apparatus is provided, the apparatus including:
an image acquisition module, configured for obtaining a to-be-processed image;
a resolution reduction module, configured for obtaining a first image that is obtained by performing resolution reduction processing on the to-be-processed image;
an image processing module, configured for performing image processing on the first image to obtain a second image; and
a resolution increase module, configured for increasing a resolution of the second image to a preset resolution as an image processing result.

In an embodiment of the present application, the resolution reduction module is specifically configured for obtaining the first image that is obtained by performing resolution reduction processing on the to-be-processed image in a preset Half mode, wherein the resolution in an image width direction is reduced by half and/or the resolution in an image height direction is reduced by half.

In an embodiment of the present application, the image acquisition module includes:
an analog-to-digital conversion unit, configured for obtaining an analog image and converting the analog image to a digital image; and
an image storage unit, configured for storing into a random memory the to-be-processed image determined based on the digital image.

In an embodiment of the present application, the resolution reduction module is specifically configured for:
obtaining the to-be-processed image from the random memory; and
obtaining the first image that is obtained by performing resolution reduction processing on the to-be-processed image in the preset Half mode.

In an embodiment of the present application, the image storage unit is specifically configured for:
directly determining the digital image as the to-be-processed image, and performing resolution reduction processing on the to-be-processed image in the preset Half mode;
storing into the random memory the to-be-processed image subjected to the resolution reduction processing;
accordingly, the resolution reduction module is specifically configured for obtaining the to-be-processed image stored in the random memory as the first image.

In an embodiment of the present application, the image acquisition module further includes:
a noise removal unit, configured for pre-processing the digital image to remove image noise in the digital image after the analog-to-digital conversion unit converts the analog image to the digital image;
accordingly, the image storage unit is specifically configured for storing into the random memory the to-be-processed image determined based on the digital image with image noise removed.

As can be seen from above, when the solutions according to the embodiments are applied for image processing, after obtaining the to-be-processed image, the first image is obtained which is obtained by performing resolution reduction processing on the to-be-processed image, and then image processing otherwise needed to be performed on the to-be-processed image is completed by performing image processing on the first image. In addition, in order to ensure that the resolution of the final image processing result is consistent with actual requirements, after obtaining the second image by performing image processing on the first image, the resolution of the second image is further performed. Since the first image is an image that is obtained by performing resolution reduction processing on the to-be-processed image, the resolution of the first image is smaller than that of the to-be-processed image. Therefore, when the solutions according to the embodiments are applied for image processing, the resolution range of the image processed by the image processing device can be expanded, thus when the solutions according to the embodiments are applied for image processing, the requirements on image resolution can be reduced.

In another yet embodiment of the present application, a computer readable storage medium is further provided, which stores a computer program therein, wherein the computer program, when executed by a processor, implements the image processing method according to the embodiments of the present application.

Specifically, the image processing method includes:
obtaining a to-be-processed image;
obtaining a first image that is obtained by performing resolution reduction processing on the to-be-processed image;
performing image processing on the first image to obtain a second image; and
increasing a resolution of the second image to a preset resolution as an image processing result.

It should be noted that other embodiments of the image processing method implemented by the computer readable storage medium are the same as the embodiments according to the foregoing method embodiment section, and will not be repeated here.

When the computer program stored in the machine readable storage medium according to this embodiment is executed to perform image processing, since the first image is an image that is obtained by performing resolution reduction processing on the to-be-processed image, the resolution of the first image is smaller than that of the to-be-processed image. Therefore, when the image processing device according to the embodiments is applied for image processing, the resolution range of the image processed by the image processing device can be expanded, thus when the image processing device according to the embodiments is applied for image processing, the requirements on image resolution can be reduced.

In another yet embodiment of the present application, a computer program product containing instructions is further provided which, when running on a computer, causes the computer to execute the image processing method according to the embodiments of the present application.

Specifically, the image processing method includes:
obtaining a to-be-processed image;
obtaining a first image that is obtained by performing resolution reduction processing on the to-be-processed image;
performing image processing on the first image to obtain a second image; and
increasing a resolution of the second image to a preset resolution as an image processing result.

It should be noted that other embodiments of the image processing method implemented by the computer readable storage medium are the same as the embodiments according to the foregoing method embodiment section, and will not be repeated here.

When the computer program product according to this embodiment runs on the computer to perform image processing, since the first image is an image that is obtained by performing resolution reduction processing on the to-be-processed image, the resolution of the first image is smaller than that of the to-be-processed image. Therefore, when the image processing device according to the embodiments is applied for image processing, the resolution range of the image processed by the image processing device can be expanded, thus when the image processing device according to the embodiments is applied for image processing, the requirements on image resolution can be reduced.

In the embodiments, it may be implemented in whole or in part by software, hardware, firmware, or any combination thereof. When implemented by software, it may be implemented in the form of a computer program product in whole or in part. The computer program product includes one or more computer instructions. When the computer program instructions are loaded and executed on the computer, the processes or functions described in the embodiments of the present application are generated in whole or in part. The computer may be a general purpose computer, a special purpose computer, a computer network, or other programmable devices. The computer instructions may be stored in a computer readable storage medium, or transmitted from one computer readable storage medium to another computer readable storage medium. For example, the computer instructions may be transmitted from one website, computer, server, or data center to another website site, computer, server or data center via wired (for example coaxial cable, optical fiber, digital subscriber line (DSL)) or wireless (for example infrared, wireless, microwave, etc.). The computer readable storage medium may be any available medium that can be accessed by a computer or a data storage device such as a server or a data center integrated with one or more available media. The available medium may be a magnetic medium (for example, a floppy disk, a hard disk, a magnetic tape), an optical medium (for example, a DVD), or a semiconductor medium (for example a solid state disk (SSD)) etc.

It should be noted that, in this description, relational terms such as first, second, and the like are only used to distinguish one entity or operation from another entity or operation without necessarily requiring or implying any actual such relationship or order between such entities or actions. Moreover, the terms "include," "comprise," or any other variation thereof are intended to cover a non-exclusive inclusion, such that a process, method, article, or device, that comprises a list of elements does not include only those elements but may include other elements not expressly listed or inherent to such process, method, article, or device. Without further limitation, an element defined by the phrase "including an ... ..." does not exclude the presence of other identical elements in the process, method, article, or device that comprises the element.

All the embodiments in the description are described in a related manner, and identical or similar parts in various embodiments can refer to one another, and each embodiment focuses on the differences from other embodiments. In particular, as for the system embodiment, the computer-readable storage medium embodiment, and the computer program product embodiment, since it is substantially similar to the method embodiment, the description is relatively simple, and reference may be made to the partial description of the method embodiment for relevant points.

The above description is only for the preferred embodiment of the present application, and is not intended to limit the scope of the present application. Any modification, equivalent replacement, improvement and the like made within the spirit and principle of the present application are included in the scope of protection of the present application.

## Claims

1. An image processing method, comprising:
obtaining a to-be-processed image;
obtaining a first image that is obtained by performing resolution reduction processing on the to-be-processed image;
performing image processing on the first image to obtain a second image; and
increasing a resolution of the second image to a preset resolution as an image processing result.

2. The method according to claim 1, wherein obtaining the first image that is obtained by performing resolution reduction processing on the to-be-processed image comprises:
obtaining the first image that is obtained by performing resolution reduction processing on the to-be-processed image in a preset Half mode, wherein a resolution in an image width direction is reduced by half and/or a resolution in an image height direction is reduced by half.

3. The method according to claim 2, wherein obtaining the to-be-processed image comprises:
obtaining an analog image and converting the analog image to a digital image; and
storing into a random memory the to-be-processed image determined based on the digital image.

4. The method according to claim 3, wherein obtaining the first image that is obtained by performing resolution reduction processing on the to-be-processed image in the preset Half mode comprises:
obtaining the to-be-processed image from the random memory; and
obtaining the first image that is obtained by performing resolution reduction processing on the to-be-processed image in the preset Half mode.

5. The method according to claim 3, wherein storing into the random memory the to-be-processed image determined based on the digital image comprising:
directly determining the digital image as the to-be-processed image, and performing resolution reduction processing on the to-be-processed image in the preset Half mode;
storing into the random memory the to-be-processed image subjected to the resolution reduction processing;
accordingly, obtaining the first image that is obtained by performing resolution reduction processing on the to-be-processed image in the preset Half mode comprises:
obtaining the to-be-processed image stored in the random memory as the first image.

6. The method according to any one of claims 3 to 5, wherein after converting the analog image to the digital image, the method further comprises:
pre-processing the digital image to remove image noise in the digital image;
accordingly, storing into the random memory the to-be-processed image determined based on the digital image comprises:
storing into the random memory the to-be-processed image determined based on the digital image with image noise removed.

7. An image processing device, comprising an image acquirer and an image processor, wherein,
the image acquirer is configured for obtaining a to-be-processed image; and
the image processor is configured for obtaining a first image that is obtained by performing resolution reduction processing on the to-be-processed image; performing image processing on the first image to obtain a second image; and increasing a resolution of the second image to a preset resolution as an image processing result.

8. The device according to claim 7, wherein
the image processor is specifically configured for obtaining the first image that is obtained by performing resolution reduction processing on the to-be-processed image in a preset Half mode, wherein a resolution in an image width direction is reduced by half and/or a resolution in an image height direction is reduced by half.

9. The device according to claim 8, wherein the image acquirer is an analog-to-digital converter, the device further comprises an image input interface and a random memory; wherein,
the analog-to-digital converter is configured for obtaining an analog image, converting the analog image to a digital image, and sending an image to the image input interface based on the digital image;
the image input interface is configured for receiving the image sent by the analog-to-digital converter, and sending an image to the random memory based on the received image; and
the random memory is configured for storing the to-be-processed image determined based on the received image.

10. The device according to claim 9, wherein
the analog-to-digital converter is specifically configured for sending the digital image to the image input interface;
the image input interface is specifically configured for sending the digital image to the random memory;
the random memory is specifically configured for storing the digital image as the to-be-processed image; and
the image processor is specifically configured for obtaining the to-be-processed image from the random memory; and obtaining the first image that is obtained by performing resolution reduction processing on the to-be-processed image in the preset Half mode.

11. The device according to claim 9, wherein
the analog-to-digital converter is specifically configured for directly determining the digital image as the to-be-processed image, performing resolution reduction processing on the to-be-processed image in the preset Half mode, and sending to the image input interface the to-be-processed image subjected to the resolution reduction processing;
the image input interface is specifically configured for sending the to-be-processed image to the random memory;
the random memory is specifically configured for storing the to-be-processed image; and
the image processor is specifically configured for obtaining an image stored in the random memory as the first image.

12. The device according to claim 9, wherein the image input interface is integrated with a resolution reduction chip;
the analog-to-digital converter is specifically configured for sending the digital image to the image input interface;
the image input interface is specifically configured for receiving the digital image sent by the analog-to-digital converter, performing resolution reduction processing on the digital image in the preset Half mode by the resolution reduction chip, and sending an image obtained by performing resolution reduction processing to the random memory by the resolution reduction chip;
the random memory is specifically configured for storing the received image as the to-be-processed image; and
the image processor is specifically configured for obtaining the to-be-processed image from the random memory as the first image.

13. The device according to any one of claims 9 to 12, wherein the device further comprises an image noise reduction chip;
the image input interface is specifically configured for receiving the digital image sent by the analog-to-digital converter, and sending the digital image to the image noise reduction chip;
the image noise reduction chip is configured for pre-processing the digital image to remove image noise in the digital image, and sending to the random memory the digital image with image noise removed; and
the random memory is specifically configured for storing the to-be-processed image determined based on the digital image with image noise removed.

14. An image processing apparatus, comprising:
an image acquisition module, configured for obtaining a to-be-processed image;
a resolution reduction module, configured for obtaining a first image that is obtained by performing resolution reduction processing on the to-be-processed image;
an image processing module, configured for performing image processing on the first image to obtain a second image; and
a resolution increase module, configured for increasing a resolution of the second image to a preset resolution as an image processing result.

15. The apparatus according to claim 14, wherein
the resolution reduction module is specifically configured for obtaining the first image that is obtained by performing resolution reduction processing on the to-be-processed image in a preset Half mode, wherein a resolution in an image width direction is reduced by half and/or a resolution in an image height direction is reduced by half.

16. The apparatus according to claim 15, wherein the image acquisition module comprises:
an analog-to-digital conversion unit, configured for obtaining an analog image and converting the analog image to a digital image; and
an image storage unit, configured for storing into a random memory the to-be-processed image determined based on the digital image.

17. The apparatus according to claim 16, wherein the resolution reduction module is specifically configured for:
obtaining the to-be-processed image from the random memory; and
obtaining the first image that is obtained by performing resolution reduction processing on the to-be-processed image in the preset Half mode.

18. The apparatus according to claim 16, wherein the image storage unit is specifically configured for:
directly determining the digital image as the to-be-processed image, and performing resolution reduction processing on the to-be-processed image in the preset Half mode;
storing into the random memory the to-be-processed image subjected to the resolution reduction processing;
accordingly, the resolution reduction module is specifically configured for obtaining the to-be-processed image stored in the random memory as the first image.

19. The apparatus according to any one of claims 16 to 18, wherein the image acquisition module further comprises:
a noise removal unit, configured for pre-processing the digital image to remove image noise in the digital image after the analog-to-digital conversion unit converts the analog image to the digital image;
accordingly, the image storage unit is specifically configured for storing into the random memory the to-be-processed image determined based on the digital image with image noise removed.

20. A computer readable storage medium, which stores a computer program therein, wherein the computer program, when executed by a processor, implements the steps of the method according to any one of claims 1 to 6.
